Europäisches Patentamt

**European Patent Office**

Office européen des brevets

(11) Publication number: **0 278 131 B1**

# EUROPEAN PATENT SPECIFICATION

(45) Date of publication of patent specification: **17.07.91**  (51) Int. Cl.⁵: **C30B 15/00, C30B 15/06**

(21) Application number: **87301086.2**

(22) Date of filing: **06.02.87**

(54) **A method for the preparation of a thin semiconductor film.**

(43) Date of publication of application:
**17.08.88 Bulletin 88/33**

(45) Publication of the grant of the patent:
**17.07.91 Bulletin 91/29**

(84) Designated Contracting States:
**DE ES FR IT NL**

(56) References cited:
**DE-A- 3 226 931**
**GB-A- 2 003 400**
**GB-A- 2 057 300**
**US-A- 4 264 641**
**US-A- 4 365 005**

(73) Proprietor: **The BOC Group plc**
**Chertsey Road**
**Windlesham Surrey GU20 6HJ(GB)**

(72) Inventor: **Robillard, Jean Jules Achille**
**28 Beechwood Road**
**Castleroy, Limerick(IE)**

(74) Representative: **Crisp, David Norman et al**
**D. YOUNG & CO. 10 Staple Inn**
**London, WC1V 7RD(GB)**

## Description

This invention relates to an electrohydrodynamic method for the preparation of a thin semiconductor film.

The prior art shows that the electrohydrodynamic technique is principally used as a research tool for testing properties of charged ions in electric propulsion sources. The full potential for the electrohydrodynamic technique for forming thin films has never been fully developed to an extent where the potential applications of this technique may be applied in a commercially useful sense.

According to the present invention there is provided a method of preparing a thin film of a semiconductor material on a substrate, comprising generating charged microdroplets of the semiconductor material or a constituent thereof by electrohydrodynamic (EHD) extraction of the said droplets from a meniscus formed at an elongate tip of a nozzle containing the material in a molten state, the EHD extraction occurring under the influence of a high electric field produced by an extractor electrode adjacent the tip of the nozzle, accelerating the microdroplets so generated away from the elongate tip of the nozzle to form a two-dimensional ribbon-like beam or blanket of the charged microdroplets, and directing the two-dimensional beam onto the trailing edge of a target carried on a moving substrate such that a film of the semiconductor material is formed on the substrate by deposition of the microdroplets on the trailing edge of the moving target.

A single source (i.e. beam or blanket) of the semiconductor material may be used, but where the semiconductor material is a compound semiconductor it may be preferable to form a separate blanket of microdroplets in respect of different constituents of the compound semiconductor, the separate blankets either being merged prior to impact on the said trailing edge of the target, or meeting at the trailing edge.

Preferably the target is a monocrystalline seed crystal of the semiconductor material and the thin film of semiconductor material is substantially monocrystalline or at least polycrystalline. However, by using a target which does not promote crystalline growth of the semiconductor material, and/or by appropriately controlling the deposition conditions, amorphous films may be formed.

The method may further include forming a separate blanket of a semiconductor doping material, the blanket of doping material and the blanket of semiconductor material or a constituent thereof either being merged prior to impact on the trailing edge of the target, or meeting at the trailing edge, whereby a doped semiconductor film is produced.

The advantages of the EHD technique reside in the high transport rate of semiconductor particles as compared to atomic flow used in thermal evaporation techniques and chemical vapor deposition. The small droplets possess a large surface to volume ratio and their electric charge allows external control of the flow rate, direction and impact energy on the substrate as well as the conditions of growth of the deposited film.

The generation of microdroplets of liquid metals and other materials by the electrohydrodynamic technique is known (Electrodydrodynamic Ion Source (J.F. Mahoney, A.Y. Yahiku, H.L. Daley, R.D. Moore and J. Perel Journal of Applied Physics (1969) Volume 40 No. 13.). The technique is, however, invariably confined to the use of cylindrical nozzles providing single beams of droplets and is applied mostly to ionic propulsion (J. Pezel, J.F. Mahoney, R.D. Moore and A.Y. Yahiku AIAA J. 7,507 (1969)). The generation of two dimensional blanket of particle is new in the art and particularly suitable for the preparation of high yield semiconductor films for microcircuit or solar cell applications. The deflection and focussing of charged particles by electron (or ion) optics is well known in the art and utilized currently in systems such as electron microscopes, ion microscopies, mass spectrographs, particle accelerators, etc.

The lateral growth of a thin monocrystalline film from the trailing edge of a seed on a moving substrate has also been investigated by several authors (Tallman R.L., T.L. Chu, J.J. Oberly Solid State Electronics 9, 327 (1966)). However, none of this work has used a two dimensional blanket of liquid particles focussed on the trailing edge of the seed to provide a controlled impact energy sufficient to initiate the growth of a monocrystalline structure.

Embodiments of the invention will now be described, by way of example, with reference to the accompanying drawings, in which:

Figure 1 is a part cross-sectional schematic perspective view of an apparatus for performing a first embodiment of the invention,

Figure 2 is an enlarged cross-sectional perspective view of the microdroplet source forming part of figure 1.

Figure 3 is an enlarged cross-sectional perspective view of an alternative microdroplet source which may be used in the apparatus of figure 1.

Figure 4 is a cross-section through one of the individual capilliary nozzles of figure 3.

Figure 5 is a schematic diagram of a semiconductor film during deposition, omitting the substrate on which it is formed, and

Figure 6 is a part cross-sectional schematic perspective view of a further apparatus for performing a second embodiment of the invention.

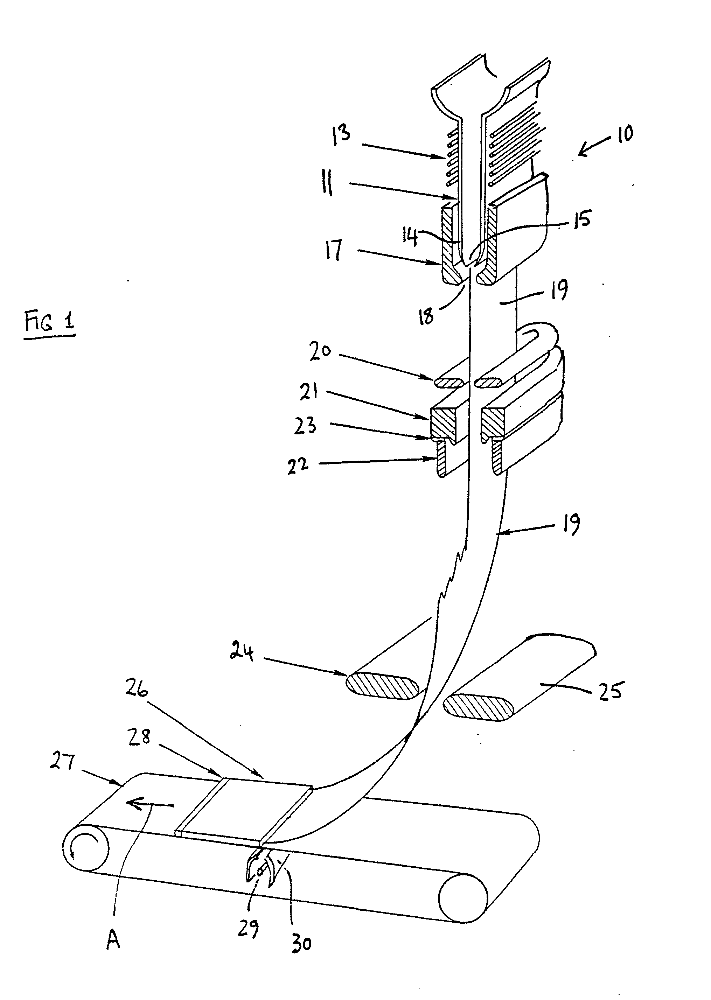

Referring to figures 1 and 2, the apparatus there shown comprises a source 10 of microdroplets of semiconductor material. In particular the source 10 includes a nozzle 11 of tungsten or other refractory material which is fed by capilliary action from a reservoir (not shown) of molten feedstock, i.e. semiconductor material 12. The material 12 in the nozzle 11 is kept molten by heat from an RF coil 13. The nozzle 11 has an elongate tip 14 which, as shown in figure 1, comprises a single elongate opening 15 at which a meniscus 16 of the molten semiconductor material 12 is formed.

The source 10 further includes an extractor electrode 17 closely embracing the tip 14 on either side and having an opening 18 vertically coincident with the opening 15. The nozzle 11 is maintained at a very high positive potential relative to the extractor electrode 17, typically 2 to 20 kV, whereby a very intense electrostatic field (e.g. $10^5$ V/cm) is applied to the meniscus 16 of the material 12. The interaction between the electrostatic field and the surface tension of the meniscus 16 disrupts the semiconductor surface, resulting in a cloud of positively charged microdroplets of the semiconductor material being formed in the vincinity of the tip 14 of the nozzle 11.

The cloud of microdroplets formed at the nozzle 11 is accelerated away from the nozzle and focussed into a two-dimensional ribbon-like beam or blanket 19 by ion optic lenses 20, 21 and 22, including an insulator ring 23 for mounting the doublet lens system 21/22.

The blanket of charged droplets is then bent through 90° by two electrodes 24 and 25 to finally impinge on the trailing edge of a target 26 which is carried on a conveyor 27 moving in the direction indicated by the arrow A. The target 26 is initially a monocrystalline seed crystal 28 of the semiconductor material which is carried on a substrate which may be the surface of the conveyor 27 itself or a separate substrate (not shown) carried on the conveyor. The substrate may be sapphire, a glass ribbon or a metal foil enamelled on one side.

Deposition of the microdroplets onto the trailing edge of the seed crystal 28 starts an epitaxial growth process leading to the formation of a thin film as the substrate moves away from the point of impact at the same rate as the rate of growth of the film. Except at the beginning, when the seed crystal 28 constitutes the target, the growing film itself constitutes the target 26 upon whose trailing edge the beam or blanket 19 is directed.

To promote epitaxial growth, the trailing edge of the target 26 is locally heated by a tungsten filament 29 and anode 30 which together provide an upwardly directed electron beam extending across the width of the conveyor below the trailing edge of the growing film 26. This local heating provided by the elements 29 and 30 may not be necessary if the density and energy of the blanket of microdroplets is sufficient to provide the necessary heating at the trailing edge solely through dissipation of the kinetic energy of the microdroplets.

Thus, the film 26 is built up by the condensing microdroplets which are focussed as a blanket upon the trailing edge of the film, the temperature of the trailing edge being maintained at the temperature required for epitaxial growth of the film. To assist in the accurate deposition on the trailing edge, both seed and growing film are maintained at a suitable negative potential relative to the positively charged microdroplets. This may be achieved in conventional manner by the use of brushes or a liquid metal contact (not shown) to make electrical contact with the moving substrate.

Since the charged blanket is focussed on, and electrostatically attracted by the trailing edge of the condensing semiconductor film, only a few scattered ions of the semiconductor can condense ahead of the trailing edge and the danger of a heterogenous nucleation is correspondingly reduced.

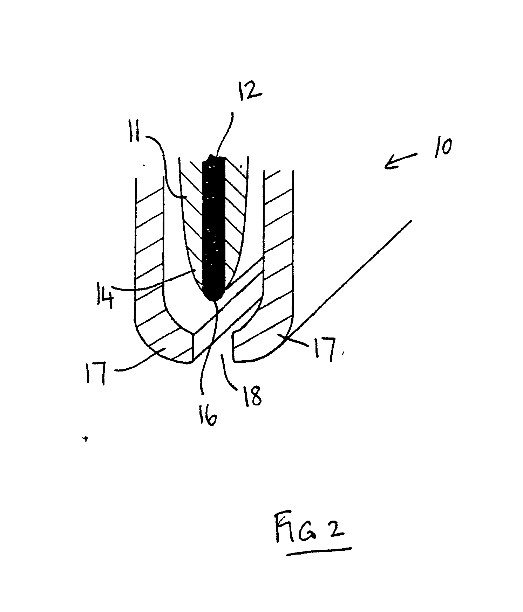

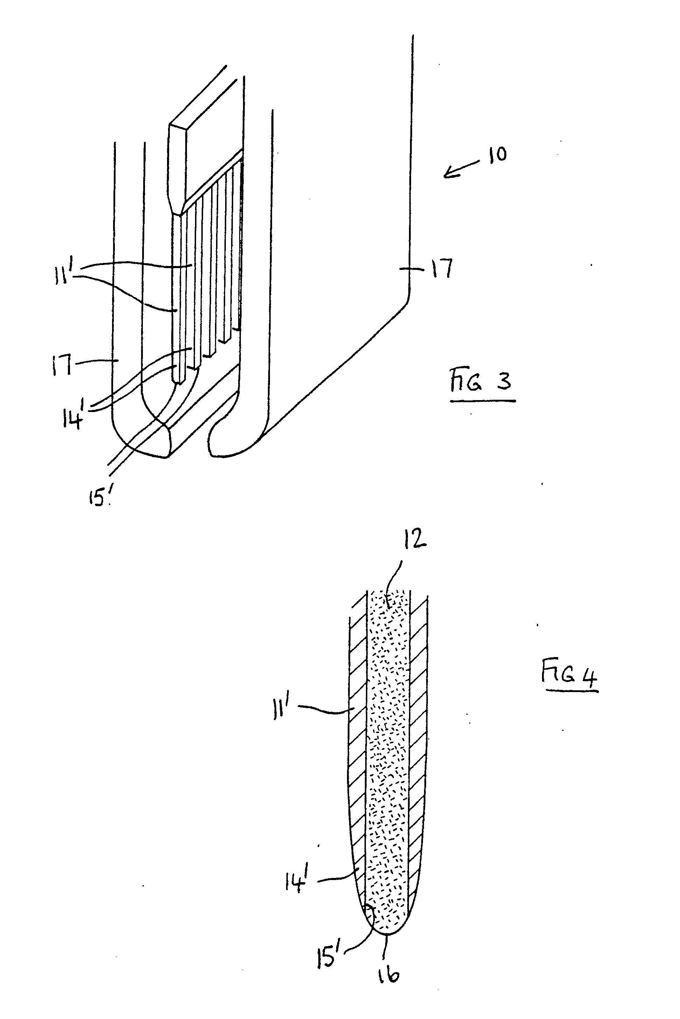

In figure 5, there is shown the film 26 which is in the process of being grown on the substrate (not shown). The condensed solid portion 32 of the film has a generally polycrystalline structure having large crystallites 33. The region of the film indicated at 34 is in a substantially liquid state and has at this stage a plurality of somewhat smaller forming crystallites 35. The region indicated at 36 is the ribbon or blanket of semiconductor droplets 19. As the seed and film are kept at a negative potential relative to the ribbon of positively charged semiconductor droplets, the latter can effectively draw an electric current. The ribbon of droplets 19 can in fact draw a current sufficient to form a lower impedance path than that in the forming thin film 26. Thus, there is established a voltage drop across the thin film which is desired to merge the forming crystallites. In the forming film, particularly in the region 34, the conductivity within the crystallites is much higher than the conductivity at the interface between two adjacent crystallites. Thus, there is a potential drop across the interface between adjacent crystallites particularly in the lateral direction, from left to right in Figure 5. This lateral potential drop across the boundaries of the crystallites, particularly in the region 34 tends to heat up the boundaries and is thus favourable for the merging and orientation of the forming crystallites into an epitaxial structure.

While such a potential drip is effective only for the total film in the case of a deposition under bias, the ion droplet blanket deposition allows the exertion of the field force directly during formation of the film structure and, therefore, eliminates a forming grain structure more efficiently.

The controllable variables in the electrohydrodynamic droplet generation method include, for example, the acceleration voltage, the electric field at the emitter, the emitter and extractor geometries, the material's physical properties, feed rate and the temperature.

Electrohydrodynamically generated droplets are controlled in terms of radius, charge-to-mass ratio and velocity. The droplet trajectory and impact energy are controllable by means of electric and magnetic fields. In general the droplet size can be increased by decreasing the electric field and/or by increasing the flow rate at the liquid feed. With increasing size the charge-to-mass ratio and the droplet velocity decrease and the time of flight from the source to the collector increases accordingly. The droplet velocity can be defined in terms of the charge-to-mass ratio and the accelerating voltage according to $\frac{1}{2} mV^2$.

The EHD source current of the emitted droplets can be determined by:

$$I = \frac{q}{m} \times M$$

Where
I is the current of the source
M is the flow rate
$\frac{q}{m}$ is the charge-to-mass ratio.

With different electrostatic field, particle sizes can be achieved for electrohydrodynamically formed particles ranging from several micrometers (up to the dimensions of the orifice of the capillary emitter) down to to submicrometer (ions).

Other processing variables which affect particle size is the position of the extractor or acceleration electrode relative to the tip of the capillary emitter and the electrostatic field. A narrow distribution of particle sizes can be achieved and particle sizes ranging from about 0.01 $\mu$m to about 100 $\mu$m.

Temperature control of the feed material in the processing apparatus provides a precise control of feed material mass flow rate. Temperature also affects the thermal as well as electrical conductivities of the feed material so that the control of temperature also permits control of particle sizes, and particle size distribution.

It is to be understood that the entire apparatus of figure 1 is located in a vacuum chamber in use, the chamber being evacuated to $1,33 \times 10^{-3}$ to $1,33 \times 10^{-4}$ Pa ($10^{-5}$ to $10^{-6}$ Torr).

An alternative form of microdroplet source 10 is shown in figures 3 and 4. In these figures the nozzle includes a plurality of individual capilliary tubes 11' of refractory material connected to a common reservoir (not shown). The tips 14' of the tubes 11' are open at the bottom 15', the individual openings 15' forming a linear array. A meniscus 16 is formed at each of the openings 15'. In the source 10 shown in figures 1 and 2 the width of the opening 15 is between $10^{-3}$ cm and $8 \times 10^{-3}$ cm, and in the source shown in figures 3 and 4 the widths of the individual openings 15' lie in this same range.

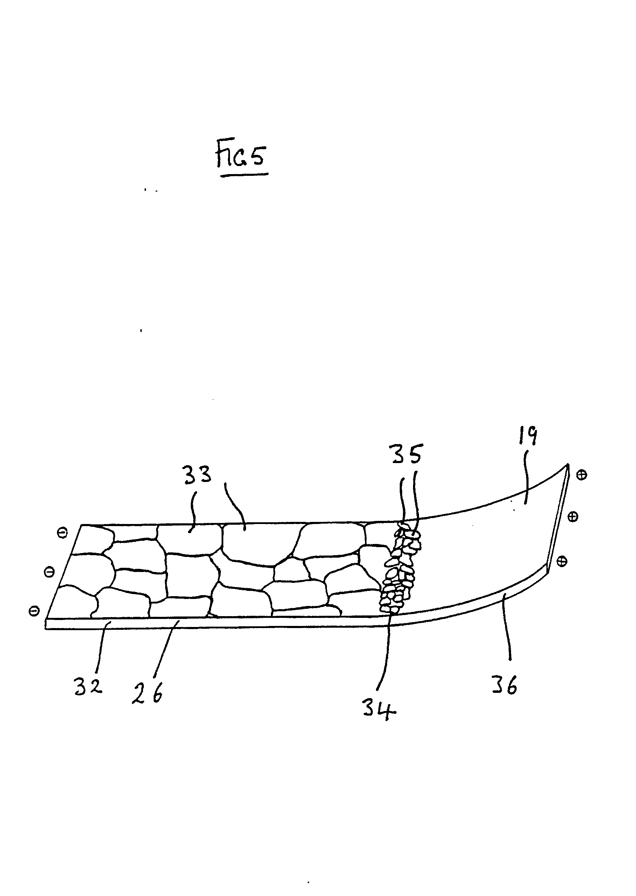

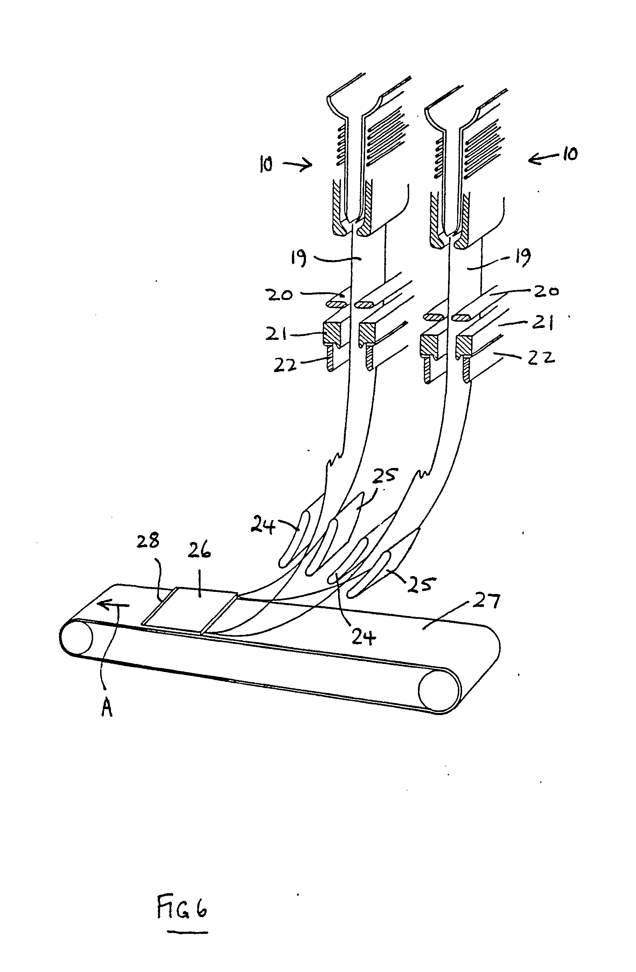

A need for high purity material deposition may demand compound formation in-situ. This can be solved by adopting the present technique in the case of a two source deposition converging on the trailing edge, see fig. 6 where the same reference numerals have been used as in figure 1. While two source deposition is known as such, blanket deposition in this case is new and leads to a combination of better materials control with higher film perfection. It is known that the usual flash evaporation used for hompolar and heteropolar semiconductors is rather crude due to particle clustering and resulting growth defect.

It is also known that in vacuum deposition of compounds such as GaAs, the partial pressure of the vapor of the more volatile component would be higher than prescribed by stochiometry. It is also known that partial pressure in an evaporation rate of ionised molecules can be monitored with great accuracy. By using separate sources for the different constituents of a compound semiconductor film they can thus vary accurately the vapour composition and maintain conditions ideal for film deposition. By separate sources we do not only mean a separate microdroplet blanket for each constituent which meet only at the target but also separate sources of constituents with a common ion optical system for uniting and collimating the originally separate constituents prior to impact on the target. The same technique may be used for forming a doped semiconductor film.

Films built up according to the description can be used to deposit contacts and insulators for the formation of active devices, like MOS and FET devices. Due to the substrate movement, a part of the film, formed as a monocrystal, can immediately be processed in device structure or parts thereof.

A non limitative list of semiconductor materials applicable to the present invention include Si, Ge, GaAs, GaP, GaAs P, $Al_2As_3$, $Al_2S_3$, AlP, $SnO_2$, $TiO_2$, $ZnO_2$, $Bi_2O_3$, $Al_2O_3$, etc. depcsited in single or compound layers from 0.1 to 50 $\mu$m thick.

In order to increase the local particle mobility at the forming film, additional film heaters can also be provided, as an example, an optical or electron beam heater can be positioned in the vicinity of the ion blanket on either side of the substrate and a radiation heater can supply radiative heat between the ion blanket and ground contact with the film. The optical or electron beam heater can be used for sharply defined local heating to promote epitaxial growth or contact may be used for annealing the film, and also for raising the semiconductor temperature to a point where it becomes more conductive and thus provides a sufficient electrically conductive path for the ion discharge current (figure 5).

## Claims

1. A method of preparing a thin film of a semiconductor material on a substrate, comprising:

   generating charged microdroplets of the semiconductor material or a constituent thereof by electrohydrodynamic (EHD) extraction of the said droplets from a meniscus formed at an elongate tip of a nozzle containing the material in a molten state, the EHD extraction occurring under the influence of a high electric field produced by an extractor electrode adjacent the tip of the nozzle,

   accelerating the microdroplets so generated away from the elongate tip of the nozzle to form a two-dimensional ribbon-like beam or blanket of the charged microdroplets, and

   directing the two-dimensional beam onto the trailing edge of a target carried on a moving substrate such that a film of the semiconductor material is formed on the substrate by deposition of the microdroplets on the trailing edge of the moving target.

2. A method according to claim 1, wherein the semiconductor material is a compound semiconductor, and a separate blanket of microdroplets is formed in respect of different constituents of the compound semiconductor, the separate blankets either being merged prior to impact on the said trailing edge of the target, or meeting at the trailing edge.

3. A method according to claim 1 or 2, wherein the target is a monocrystalline seed crystal of the semiconductor material and the thin film of semiconductor material is substantially monocrystalline or at least polycrystalline.

4. A method according to claim 3, further including forming a separate blanket of a semiconductor doping material, the blanket of doping material and the blanket of semiconductor material or a constituent thereof either being merged prior to impact on the said trailing edge of the target, or meeting at the trailing edge, whereby a doped semiconductor film is produced.

5. A method according to any preceding claim, wherein the elongate tip of the nozzle includes a single elongate opening at which the meniscus is formed.

6. A method according to any one of claims 1 to 4, wherein the elongate tip of the nozzle includes a linear array of a plurality of individual openings at each of which a meniscus is formed

7. The method of any preceding claim, wherein a voltage is applied between the extractor electrode and the nozzle of between 2 and 20 kV to provide the said high electric field.

8. The method of claim 5 or 6, wherein the width of the single nozzle opening, or the width of each individual nozzle opening, is from $10^{-3}$ cm to $8 \times 10^{-3}$ cm.

9. The method of any preceding claim, wherein the target on the moving substrate is negatively biased with respect to the positively charged microdroplets.

10. The method of any preceding claim, wherein additional heating is provided at the trailing edge of the target by directing an electron beam along the trailing edge.

11. The method of any preceding claim, which is carried out in a vacuum chamber at $1,33 \times 10^{-3}$ to $1,33 \times 10^{-4}$ Pa ($10^{-5}$ to $10^{-6}$ Torr).

## Revendications

1. Un procédé pour la préparation d'une pellicule mince d'un matériau semiconducteur sur un substrat, comprenant les opérations consistant :

   à générer des microgouttelettes chargées formées du matériau semiconducteur ou d'un constituant de celui-ci par extraction électrohydrodynamique (EHD) desdites gouttelettes à un ménisque formé au niveau d'une pointe allongée d'une buse contenant le matériau dans un état fondu, l'extraction EHD ayant lieu sous l'influence d'un champ électrique élevé créé par une électrode extractrice adjacente à la pointe de la buse,

   à accélérer les microgouttelettes ainsi générées en les éloignant de la pointe allongée de la buse pour former un faisceau bidimensionnel en forme de ruban ou matelas des microgouttelettes chargées, et

   à diriger le faisceau bidimensionnel sur le bord arrière d'une cible supportée par un substrat en mouvement de telle façon qu'il se forme une pellicule du matériau semiconducteur sur le substrat par dépôt des microgouttelettes sur le bord arrière de la cible en mouvement.

2. Un procédé selon la revendication 1, dans lequel le matériau semiconducteur est un semiconducteur à plusieurs constituants, et un matelas distinct de microgouttelettes est formé pour les différents constituants du semiconducteur à plusieurs constituants, les différents matelas étant fusionnés avant de frapper ledit bord arrière de la cible, ou bien se rejoignant au bord arrière.

3. Un procédé selon la revendication 1 ou 2, dans lequel la cible est un germe monocristallin du matériau semiconducteur et la pellicule mince de matériau semiconducteur est sensiblement monocristalline ou au moins polycristalline.

4. Un procédé selon la revendication 3, comprenant en outre la formation d'un matelas distinct d'un matériau de dopage de semiconducteur, le matelas de matériau de dopage et le matelas de matériau semiconducteur ou d'un constituant de celui-ci étant fusionnés avant de frapper ledit bord arrière de la cible ou bien se rejoignant au bord arrière, en fournissant ainsi une pellicule de semiconducteur dopé.

5. Un procédé selon l'une quelconque des revendications précédentes, dans lequel la pointe allongée de la buse comporte un orifice allongé unique au niveau duquel est formé le ménisque.

6. Un procédé selon l'une quelconque des revendications 1 à 4, dans lequel la pointe allongée de la buse comprend un alignement de plusieurs orifices individuels au niveau de chacun desquels est formé un ménisque.

7. Le procédé selon l'une quelconque des revendications précédentes, dans lequel une tension électrique comprise entre 2 et 20 kV est appliquée entre l'électrode extractrice et la buse pour créer ledit champ électrique élevé.

8. Le procédé selon la revendication 5 ou 6, dans lequel la largeur de l'orifice de la buse unique ou la largeur de l'orifice de chaque buse individuelle est de $10^{-3}$ à $8 \times 10^{-3}$ cm.

9. Le procédé selon l'une quelconque des revendications précédentes, dans lequel la cible portée par le substrat en mouvement est polarisée négativement par rapport aux microgouttelettes chargées positivement.

10. Le procédé selon l'une quelconque des revendications précédentes, dans lequel un chauffage additionnel est créé au bord arrière de la cible dirigeant un faisceau d'électrons le long du bord arrière.

11. Le procédé selon l'une quelconque des revendications précédentes, qui est mis en oeuvre dans une chambre à vide sous un vide de 1,33 $\times 10^{-3}$ à 1,33 $\times 10^{-4}$ Pa ($10^{-5}$ à $10^{-6}$ Torr).

**Patentansprüche**

1. Verfahren zur Herstellung eines dünnen Films aus Halbleitermaterial auf einem Substrat mit folgenden Schritten:

   Erzeugung von geladenen Mikrotröpfchen des Halbleitermaterials oder eines Bestandteiles davon durch elektro-hydrodynamische Entnahme der Tröpfchen aus einer das Material in geschmolzenem Zustand enthaltenden, an einer langgestreckten Spitze einer Düse ausgebildeten Kuppe, wobei die elektro-hydrodynamische Entnahme unter dem Einfluß eines hohen elektrischen Feldes erfolgt, das durch eine Entnahmeelektrode im Bereich der Spitze der Düse erzeugt wird,

   von der langgestreckten Spitze der Düse weggerichtete Beschleunigung der so erzeugten Mikrotröpfchen zur Bildung eines zweidimensionalen bandförmigen Strahls oder Mantels der geladene Mikrotröpfchen, und

   Führung des zweidimensionalen Strahls auf den hinteren Rand eines von einem sich bewegenden Substrat getragenen Ziels, derart, daß auf dem Substrat durch Abscheiden der Mikrotröpfchen auf dem hinteren Rand des sich bewegenden Ziels ein Film des Halbleitermaterials gebildet wird.

2. Verfahren nach Anspruch 3, bei dem das Halbleitermaterial ein Verbindungshalbleiter ist und in Bezug auf die unterschiedlichen Bestandteile des Verbindungshalbleiters gesonderte Mäntel von Mikrotröpfchen gebildet werden, die entweder vor dem Auftreffen auf dem hinteren Rand des Ziels gemischt werden oder sich am hinteren Rand treffen.

3. Verfahren nach Anspruch 1 oder 2, bei dem das Ziel ein einkristalliner Impfkristall des Halbleitermaterials und der dünne Film aus Halbleitermaterial im wesentlichen einkristallin oder wenigstens polykristallin ist.

4. Verfahren nach Anspruch 3, bei dem ein gesonderter Mantel eines Halbleiter-Dotierungsmaterials gebildet wird und der Mantel aus Dotierungsmaterial und der Mantel aus Halbleitermaterial oder eines Bestandteiles davon entweder vor dem Auftreffen auf dem hinteren Rand des Ziels gemischt werden oder sich am hinteren Rand treffen, wodurch ein dotierter Halbleiterfilm erzeugt wird.

5. Verfahren nach den vorhergehenden Ansprüchen, bei dem die langgestreckte Spitze der Düse eine einzige langgestreckte Öffnung aufweist, an der die Kuppe ausgebildet ist.

6. Verfahren nach den Ansprüchen 1 bis 4, bei dem die langgestreckte Spitze der Düse eine lineare Reihe mehrerer Einzelöffnungen enthält, an denen jeweils eine Kuppe ausgebildet ist.

7. Verfahren nach den vorhergehenden Ansprüchen, bei dem zur Erzeugung des hohen elektrischen Feldes zwischen der Entnahmeelektrode und der Düse eine Spannung zwischen 2 und 20 kV angelegt wird.

8. Verfahren nach Anspruch 5 oder 6, bei dem die Breite der einzigen Düsenöffnung oder die Breite jeder einzelnen Düsenöffnung $10^{-3}$ bis $8 \times 10^{-3}$ cm beträgt.

9. Verfahren nach den vorhergehenden Ansprüchen, bei dem das Ziel auf dem sich bewegenden Substrat in Bezug auf die positiv geladenen Mikrotröpfchen negativ vorgespannt wird.

10. Verfahren nach den vorhergehenden Ansprüchen, bei dem am hinteren Rand des Ziels durch Führung eines Elektronenstrahls längs dieses hinteren Randes eine zusätzliche Erwärmung erfolgt.

11. Verfahren nach den vorhergehenden Ansprüchen, das in einer auf einem Druck von $1,33 \times 10^{-3}$ bis $1,33 \times 10^{-4}$ Pa befindlichen Kammer durchgeführt wird.

FIG 1

FIG 2

FIG 3

FIG 4

FIG5

FIG 6